# EUROPEAN PATENT APPLICATION

(11) **EP 4 730 186 A1**
(43) Date of publication of application: **22.04.2026**
(21) Application number: 25208831.5
(22) Date of filing: 15.10.2025
(51) Int. Cl.: G06F 30/12, G06F 30/20, G06F 30/23

(54) **ASSUMPTION CHECKER**

(30) Priority: 15.10.2024 US 202463707428 P
(71) Applicant: Dassault Systemes SolidWorks Corporation, Waltham, MA 02451-1223 (US)
(72) Inventor: Greenwood, Steven, Broomfield (US); Huang, Li-Ling, Woodland Hills (US); Pollock, Gerry, Johnston (US)
(74) Representative: Bandpay & Greuter

(57) **Abstract**

A computer-based method includes receiving data indicating whether each of a plurality of linear metrics produced by a linear analysis of a computer model in a computer-implemented simulation violated any linear analytic assumptions. Status icons are displayed on a graphical user interface (GUI), with each status icon being visually associated with a corresponding one of the plurality of the linear metrics and a corresponding model element of the computer-implemented model. Each of the model elements is displayed on the graphical user interface in a manner that represents a hierarchical model structure of the model elements within the computer-implemented model. Each status icon provides a visual indication of whether the corresponding one of the plurality of linear metrics for the corresponding one of the plurality of model elements produced by the linear analysis of the computer-implemented model in the computer-implemented simulation violated any of the linear analytical assumptions.

## Description

### CROSS-REFERENCE TO RELATED APPLICATION(S)

This application claims the benefit of U.S. Provisional Patent Application No. 63/707,428, which was filed on October 15, 2024 and entitled *Assumption Checker*, and is hereby incorporated by reference in its entirety.

### FIELD OF THE INVENTION

This disclosure relates to the field of computer-implemented simulation typically involving a computer-based model and, more particularly, relates to facilitating a user's understanding of reliability in the results of such a computer-implemented simulation.

### BACKGROUND

Simulating real world phenomena can be done using linear or nonlinear analysis. Nonlinear analysis is capable of handling certain real-world complexities that linear analysis is not well suited to handle. However, nonlinear analysis tends to be slower, far more complicated, and more resource intensive than linear analysis. Linear analysis can be faster, simpler and computationally inexpensive compared to nonlinear analysis. However, linear analysis is generally only reliable if certain assumptions apply and are honored by the analysis results.

### SUMMARY OF THE INVENTION

A computer-based method includes receiving data that indicates whether each respective one of a plurality of linear metrics produced by a linear analysis of a computer-implemented model in a computer-implemented simulation represents a violation of any linear analytic assumptions (based, e.g., on data and programming in computer memory that enables a determination in this regard to be established). Status icons are produced and displayed, on a graphical user interface (GUI), with each status icon being visually associated with a corresponding one of the plurality of linear metrics and a corresponding one of a plurality of model elements that make up the computer-implemented model. Each model element is displayed (e.g., presented in a nested list) on the graphical user interface in a manner that represents a hierarchical model structure of the model elements within the computer-implemented model. Each status icon provides a visual indication (e.g., color-coded, and/or including words, such as pass, fail, or warning) of whether the corresponding one of the plurality of linear metrics for the corresponding one of the plurality of model elements produced by the linear analysis of the computer-implemented model in the computer-implemented simulation violated any of the linear assumptions.

Displaying the status icons on the graphical user interface may include displaying the hierarchical model structure as an onscreen visual representation with a plurality of the model elements presented in a nested arrangement in accordance with their respective relationships within the hierarchical model structure. Each model element may represent a product structure, a shape, or a body in the computer-implemented model. In a typical implementation, the computer-implemented model will be made up of one or more of the product structures, each product structure may be made up of one or more shapes, and each shape may be made up of one or more bodies. The status icons may be arranged in an array with each respective one of the status icons being visually associated with the corresponding one of the plurality of linear metrics and the corresponding one of the plurality of model elements from the computer-implemented model by virtue of a row and column location of that status icon within the array.

In some implementations, the computer-based method also includes enabling a user to select any one or more of the status icons displayed on the graphical user interface and, in response to the user selecting a particular one of the status icons, displaying, on the graphical user interface, a three-dimensional visual representation of at least the product structure, shape, or body that corresponds to the selected status icon. The three-dimensional visual representation of at least the product structure, shape, or body that corresponds to the selected status icon may have a visual appearance (e.g., color) that reflects (e.g., based on an onscreen color key) whether the selected status icon represents a violation of any of the linear analytic assumptions (e.g., a pass, fail, or warning status).

In a typical implementation, each of the status icons is either a pass status icon, a fail status icon, or a warning status icon. In those implementations, a pass status icon may be assigned to (and displayed in logical association with) a first one of the linear metrics for a first one of the model elements in response to a determination that the computer-implemented simulation that produced the first one of the linear metrics did so without violating any of the linear analytical assumptions, and/or a fail status icon may be assigned to (and displayed in logical association with) a second one of the linear metrics for a second one of the model elements in response to a determination that the computer-implemented simulation that produced the second one of the linear metrics did so in a manner that violated one or more of the linear analytical assumptions. In some implementations, the computer-based method further includes assigning a warning status icon to a third one of the linear metrics for a third one of the model elements in response to a determination that the computer-implemented simulation that produced the third one of the linear metrics did so in a manner that did not satisfy criteria for assignment of a pass status icon or a fail status icon. In a typical implementation, the pass status icon, the fail status icon, and the warning status icon have different visual appearances (e.g., colors, symbols, and/or words) on the graphical user interface.

In some implementations, the visual representation of the product structure, shape, or body that corresponds to the selected status icon appears as a portion of the computer-implemented model and is shown with a first style of appearance on the graphical user interface. In some such instances, other portions of the computer-implemented model that do not correspond to the selected status icon are visually represented on the graphical user interface with a second style of appearance on the graphical user interface. The first style of appearance is visually distinct from the second style of appearance. In one example of this, the first style of appearance may be a solid, opaque appearance and the second style of appearance is a transparent appearance. Variations are possible, of course.

In some implementations, when the portions of the computer-implemented model appear onscreen, the portions may be displayed on the graphical user interface simultaneously as and adjacent to a table that includes all of the status icons.

The computer-implemented simulation may be a linear static structural simulation (though other variations are possible), and the analytical assumptions are stored in computer memory and are that 1) materials involved in the computer-implemented simulation are linear elastic with no material nonlinearity, 2) displacements and rotations do not exceed a predefined threshold, and 3) contact slip magnitudes do not exceed a predefined threshold. The linear metrics in such implementations may be yield, strain, sliding, and displacement.

In some implementations, the computer-implemented method includes displaying, on the graphical user interface, a comprehensive status icon for each respective one of the model elements in the hierarchical model structure for the computer-implemented model. In such instances, each comprehensive status icons identifies, and has a visual appearance (e.g., color, pattern, label, etc.) that reflects a linear analytical assumptions compliance status (e.g., pass, fail, warning) that corresponds to a worst one of the corresponding linear metrics for the associated one of the model elements from a perspective of compliance with the linear analytical assumptions.

In a typical implementation, the computer-implemented simulation is based on a simulation model representing a real-world scenario in which a product represented by the computer-based model is subjected to various environmental boundary conditions in conducting the computer-implemented simulation.

In another aspect, a computer includes a computer processor; and computer-based memory operatively coupled to the computer processor, wherein the computer-based memory stores computer-readable instructions that, when executed by the computer processor, cause the computer to perform the aforementioned computer-implemented method(s) and/or variations thereof disclosed herein.

In yet another aspect, a non-transitory computer readable medium is disclosed that has stored thereon computer-readable instructions that, when executed by a computer-based processor, cause the computer-based processor to perform the aforementioned computer-implemented method(s) and/or variations thereof disclosed herein.

In some implementations, one or more of the following advantages are present.

For example, the systems and techniques disclosed herein may facilitate a better understanding of reliability in a computer-generated simulation results produced from a simulation based on a computer-based model. More specifically, in a typical implementation, the systems and techniques disclosed herein may facilitate a better understanding of whether any requisite analytical assumptions were honored or violated such simulations. The systems and techniques typically provide feedback in this regard through an interface that is intuitive and easy to navigate. The feedback provided is specific and identifies, for example, any impacted linear metrics produced from the simulation and to which portions of the model such feedback applies. This may enable users to easily and quickly modify models and/or simulation profiles, if needed, and know when a particular set of simulation outputs are reliable. Existing applications that are suitable for linear static structural simulation do not generally provide users with access to data or plots necessary to assess adherence to linearity assumptions in a simulation. The systems and techniques disclosed herein bypass the need for a user to access such underlying data or plots and instead provide the user with a clear, intuitive assessment of such adherence and enables the user to navigate to meaningful data regarding same in a further intuitive manner.

In a typical implementation, the systems and techniques disclosed herein provide a clear indication of whether linear assumptions are violated in a particular simulation, automatically assess whether simulation results honor linear assumptions for small-sliding contact, infinitesimal strain theory (small displacements and rotations), and material linearity (not exceeding yield stress or elastic limit strain), provide a user interface that will enable users (e.g., designers and design engineers) to quickly assess whether their simulation results are trustworthy using intuitive Pass | Fail | Warning status indicators, and provide an intuitive user interface with selection-cross-highlighting to guide the user to problematic areas.

Thus, in a typical implementation, the systems and techniques disclosed herein provide a fully integrated tool to identify whether linear assumptions are violated. This may include, for example, a multiple-linear-metric-driven user experience to assess linear assumptions against limit values (stored in computer memory), visual feedback configured to draw user attention to specific problem areas, normalized plots for easy assessment of linear metrics, and ability to assess validity of results, which is not possible today with at least some of the designer simulation apps (e.g., Static Study, Linear Structural Validation). Users, expert and non-expert alike, will gain confidence in simulation results, likely leading to increased usage of simulation and improvements in product design as a result.

Other features and advantages will be apparent from the description and drawings, and from the claims.

### BRIEF DESCRIPTION OF THE DRAWINGS

FIG. 1 is a schematic representation of a computer configured to execute the computer-implemented functionalities described herein.
FIG. 2 is a flowchart of an implementation of a computer-implemented simulation and simulation review process.
FIG. 3 shows an exemplary implementation of a screenshot that includes a three-dimensional depiction of a computer-based model in a computer-implemented simulation environment.
FIG. 4 shows an exemplary implementation of a screenshot that includes a pop-up window of the type that may appear after the computer 100 completes a simulation.
FIG. 5 shows an exemplary implementation of a screenshot that includes a depiction of a contour plot of Von Mises Stress.
FIG. 6 shows an exemplary implementation of a screenshot that shows a cursor hovering over a user-selectable icon for activating the assumption checker functionalities.
FIGS. 7 -14 show exemplary implementations of screenshots from an assumption checker graphical user interface.
FIG. 15 show an exemplary implementation of a step, plot, and frame selector UI component for results navigation.
FIGS. 16 and 17 shows a zoomed-in, detailed and annotated view of an exemplary screenshot from an assumption checker graphical user interface.
FIG. 18 shows an exemplary implementation of an assumption checker-style graphical user interface applied to another type of simulation.
FIG. 19 shows an object at different stages of being exposed to stress and strain over time and a plot of stress and strain adjacent to the object.

### DETAILED DESCRIPTION

This document uses a variety of terminology to describe its inventive concepts. This terminology should be given its ordinary meaning and, unless otherwise indicated, may be understood as having meanings that are consistent with what follows.

For example, computer-aided design (CAD) software allows a user to construct and manipulate potentially complex three-dimensional (3D) models. SOLIDWORKS^{®} computer software and CATIA^{®} computer software, both of which are available from Dassault Systèmes, are examples of CAD software that may be used, for example, to construct and manipulate complex three-dimensional (3D) models. A "design engineer" is a typical user of a 3D CAD system. The design engineer typically designs physical and aesthetic aspects of 3D models and may be skilled in 3D modeling techniques. The design engineer typically creates parts and may assemble certain parts into a subassembly. A subassembly may also consist of other subassemblies. An assembly may be designed using parts and subassemblies. Parts and subassemblies may be collectively referred to as components. The phrase "design engineer" used herein should be construed broadly to include any one or more human users of a computer or computer system implementing the techniques disclosed herein.

Computer simulations analyze the behavior or outcome of a real-world product, system, process, etc. in a virtual environment using a computer-implemented model designed to represent the behavior, or outcome, of the real-world product, system, etc. subjected to boundary conditions applied in the equivalent real-world environment. Some computer applications that perform computer simulation may be configured to perform linear simulations to approximate the behavior or outcome. Linear simulation can, in various implementations, provide adequate information while reducing computational cost and/or simplifying an otherwise complex physics-based simulation, for example. For a linear simulation to be reliable, however, certain assumptions need to apply. In a linear static structural simulation, for example, these assumptions include: 1) materials are linear elastic (no material nonlinearity), 2) displacements and rotations are considered small (infinitesimal strain theory), and 3) contact slip magnitudes are small (small-sliding approximation). If a linear static structural simulation, for example, violates any (or all) of the foregoing mechanical assumptions by a sufficient degree, then the results of the simulation may be unreliable and incorrect. Other types of assumptions may apply to other types of linear simulations.

The phrase "status icon," as used herein, refers to a graphical symbol that conveys meaning through its visual appearance to help a user to understand information being conveyed and/or to navigate within a particular computer-implemented environment. Examples of "status icons" would include graphical symbols that include a red "x" to identify failure or a fail condition, a yellow triangle (optionally containing a black exclamation point) to identify a warning condition, and a green check mark to identify acceptability or a pass condition. In some implementations, a status icon may function as a link or file shortcut, for example, to additional information about the condition associated with the status icon. For example, a red "x" that identifies a fail condition may function as a link or file shortcut to information about a particular violation of a linear assumption in computer simulation, such that a user's selection of a red "x" status icon may cause the computer to display a portion of a model and/or simulation results involved in an associated linear assumption violation. Likewise, a user's selection of a yellow triangle status icon may cause the computer to display a portion of a model and/or simulation results involved in an associated warning of a potential linear assumption violation.

A linear metric, as the phrase is used herein, refers to a type of measurement that may be represented and determined, for example, by a computer simulation involving a computer-implemented simulation model. A few examples of linear metrics, in a structural simulation, include yield, strain, sliding, and displacement. A yield point is a point on a stress-strain curve that indicates the limit of elastic behavior and the beginning of plastic behavior. Strain refers to a relative deformation compared to a reference position. Sliding refers to a type of relative motion between two surfaces in contact. Displacement refers to a distance moved by a particle or body in a specific direction. Linear metrics may be determined by a computer simulation involving a computer-implemented model. Results of a linear simulation are incorrect if, for example, one or more analytical assumptions were violated in the computer simulation. In short, linear metrics are measured in order to assess the validity of the linear assumptions inherent in the underlying formulation used for the analysis.

A computer-implemented model is comprised of one or more model elements. The phrase "model element," as used herein, may refer to either a product structure, shape, or body that collectively make up the computer-implemented model. In certain implementations, a computer-implemented model may be made up of one or more product structures, each product structure may be made up of one or more shapes, and each shape may be made up of one or more bodies. A computer-implemented model, therefore, can be represented or organized into a hierarchical model structure that includes one or more product structures, one or more shapes, and/or one or more bodies. An onscreen visual representation of such a hierarchical model structure may include a nested listing of product structures, shapes and/or bodies arranged and nested in accordance with their respective positions and relationships within the hierarchy. There are, of course, multiple kinds of "computer-implemented models." For example, there is also a simulation model (the computer model representing the physical environment that the physical product is being subjected to and for which the engineer is seeking insight for design iteration direction or to validate the design against key performance indicators and criteria.

As referred to herein, the phrase "product structure" may refer to a feature-tree-based view of all physical products, 3D parts, and representations (e.g., in a computer-implemented model). As used herein, the phrase "physical product" may refer to a product lifecycle management (PLM) object that affords the user the flexibility to author a single part or an assembly of parts and/or sub-assemblies. In simple terms, this is used to create assemblies and/or sub-assemblies from any number of parts. As used herein, the phrase "3D Part" refers to a special version of a Physical Product that allows for only a single CAD 3D Shape representation. In simple terms, this may be used to represent a single component/piece/part, for example. As used herein, the term, "assembly" refers to two or more parts positioned relative to each other (e.g., to form at least a part of a computer-implemented model). This can also be referred to as a Physical Product. As used herein, the term "sub-assembly" refers to an assembly of parts that is added and positioned in a larger assembly. As used herein, the phrase "3D Shape" refers to a 3D geometrical representation of a CAD geometry (e.g., for a computer-implemented model). A Physical Product can have multiple 3D Shapes. A 3D Part can generally have one and only one 3D Shape. As used herein, a "Body" is a collection of CAD features that represent a region of geometry.

An array is a visual arrangement of items (e.g., status icons) into a table with rows and columns. In one exemplary implementation, each data row in an array may identify and correspond to a particular one of a plurality of model elements (e.g., either a product structure, a shape, or a body) that make up a computer-implemented model and each data column in the array may identify and correspond to a particular one of a plurality of a linear metrics (e.g., yield, strain, sliding, or displacement) produced in a computer simulation involving the computer-implemented model. In a typical implementation, each cell of the array is populated by a selected one of a plurality of status icons that identifies a non-binary status (e.g., pass, fail, or warning) as to whether any linear assumptions were, or may have been, violated in conducting the computer simulation and producing the corresponding linear metrics for the associated model element.

In some implementations, an array may include a further (comprehensive or summary) data column that indicates whether linear assumptions were violated (e.g., in a meaningful way) in producing any of the linear metrics for the associated model element. In a typical implementation, the computer populates a cell in the further (comprehensive) data column with a fail status icon if linear assumptions were violated in producing any of the linear metrics for the associated model element. Moreover, in a typical implementation, the computer populates a cell in the further (comprehensive) data column with a pass status icon if linear assumptions were not violated in producing any of the linear metrics for the associated model element. Additionally, in a typical implementation, the computer populates a cell in the further (comprehensive) data column with a warning status icon if linear assumptions may have been violated in producing any of the linear metrics for the associated model element. In other words, if all of the array cells for the linear metrics for a particular one of the model elements are populated with pass status icons, then the further (comprehensive) data column will be populated with a pass status icon. If any of the array cells for the linear metrics for a particular one of the model elements is populated with fail status icons, then the further (comprehensive) data column will be populated with a fail status icon. If the array cells for the linear metrics for a particular one of the model elements is populated with only warning status icons (or a mix of warning and pass status icons), but no fail status icons, then the further (comprehensive) data column will be populated with a warning status icon.

Unless otherwise indicated, the term "linear" as used herein generally implies linear elastic materials, small strains (material dependent), small rotations, and "linearized" small-sliding contact conditions. Unless otherwise indicated, the phrase "nonlinear" as used herein implies that there may be nonlinear materials, there may be finite (large) strains, plasticity or hyper elasticity, there may be finite rotations, and/or there may be finite sliding contact condition changes. Generally speaking, the actual real-world version of any simulated scenario involving a real-world version of a modeled object will be nonlinear. Linear analysis, however, when appropriately used can provide valuable insight in reduced time and, therefore, provide efficient outputs as they are generally easier to solve. However, linear analysis must be used with care as violating linear assumptions may produce incorrect results.

The phrase "processor" (or the like) refers to any one or more computer-based processing devices. A computer-based processing device is a physical component (e.g., a CPU) that can perform computer functionalities by executing computer-readable instructions stored in memory. If there is more than one computer-based processing device or processor cores, they can be contained in a single physical device (e.g., in a single a computer or server) or distributed across multiple physical devices that may be located, for example, in more than one physical location or facility.

The phrase "memory" (or the like) refers to any one or more computer-based memory devices. A computer-based memory device is a physical component that can store computer-readable instructions that, when executed by a processor, results in the processor performing associated computer functionalities. If there is more than one computer-based memory device, they can be contained in a single physical device (e.g., a computer or server) or distributed across multiple physical devices that may be in more than one physical location or facility.

One focus of this disclosure is to describe systems and techniques that facilitate understanding the reliability of results obtained from computer-implemented simulations involving computer-implemented models. These systems and techniques can be used to ensure effective modeling and simulation, which, ultimately, may lead to better products, systems, etc. more efficiently. These products, systems, etc. may be manufactured in a number of potential ways. In one example, a product, for example, may be manufactured utilizing a real-world machine automatically controlled via a computer numerical control (or "CNC") arrangement. The phrase "computer numerical control" or "CNC" refers to the automatic control of one or more machining tools, such as lathes, drills, grinders, routers, mills, 3D printers, etc. by means of a computer. A "CNC machine" is a machine that includes one or more such machining tools and that is configured to process a piece of material (e.g., metal, plastic, ceramic, wood, composite, etc.) to meet specifications by following coded programmed instructions and without a manual operator directly controlling the machining operation. Instructions may be delivered to a CNC machine from a computer (e.g., one configured to provide the functionalities disclosed herein) in the form of a sequential program of machine control instructions, and then executed by the CNC machine. In some instances, the program may have been generated by or from CAD software and/or computer-aided manufacturing ("CAM") software (e.g., based on a model that was generated using the CAD/CAM software). In such instances, the object's mechanical dimensions, for example, may have been defined using the CAD software and then translated into manufacturing directives (e.g., by corresponding CAM software). The resulting directives may be utilized as (or to provide) CNC-compatible commands necessary for a particular CNC machine to perform manufacturing operations in connection with producing a real-world version of the object. The CNC-compatible commands may be loaded into and executed by the CNC machine to perform real-world manufacturing operations (e.g., subtractive operations) on one or more pieces of material (e.g., metal, plastic, ceramic, wood, composite, etc.).

### Technical Disclosure

As mentioned above, computer simulation applications are configured to analyze computer-implemented models that are designed to represent the behavior, or outcome, of a real-world or physical product, system, process, etc. Computer simulations may implement linear analyses, non-linear analyses, or a combination thereof. Non-linear analysis tends to be highly accurate, but time-consuming and resource intensiveness. Linear analysis can be quicker, less resource intensive, and produce acceptable results as long as certain underlying assumptions about the nature and behavior of the object(s) being modeled are not violated.

Some computer simulation applications are configured to perform linear simulations of computer-implemented models, sometimes as a standalone functionality, sometimes as an alternative to a non-linear computer simulation option. Linear simulations can be appropriate under certain circumstances and, in various implementations, can be advantageous in reducing computational cost and simplifying the simulation process. Linear simulations can be significantly easier to produce and generally run faster and more robustly than a fully non-linear physics-based simulation, and may be desirable especially when the complete physics of a particular problem are not fully understood or represented by available data. Linear simulations are generally accurate only when certain linear assumptions apply. In a typical linear static structural simulation, for example, these linear assumptions may include any one or more (or all) of the following three mechanical assumptions: 1) that the materials in the simulation are linear elastic (no material nonlinearity), 2) that any displacements and/or rotations are small (infinitesimal strain theory), and 3) that any contact slip magnitudes are small (small-sliding approximation).

In a typical implementation, the assumption that the materials in the simulation are linear elastic means that the material behavior is idealized as both linear and elastic, with no material nonlinearity such as plasticity, creep, or damage. Stress is proportional to strain and follows Hooke's law, where σ=E·ε, and σ = stress, ε = strain, and E = Young's modulus (a constant). Thus, the stress-strain curve is assumed to be a straight line. The assumption that the materials in the simulation are linear elastic also may mean that the material is elastic (i.e., it does not experience any permanent deformation). Thus, after an applied load has been removed, the material returns to its original shape.

In a typical implementation, the assumption that displacements and rotations are small means that the movement of points in the structure from their original positions is so small that the geometry of the structure does not significantly change, and that the original configuration, therefore, can be used for calculations of internal forces and stresses. In a typical implementation, the assumption that any rotations are small means that any rotation of structural elements is small enough that the sine and tangent of rotation angles can be approximated by the angle itself (in radians): sin(θ)≈θ, tan(θ)≈θ, and/or that higher-order terms in the strain-displacement relationship can be ignored.

In a typical implementation, the assumption that any contact slip magnitudes are small means that relative displacement (slips) between contacting surfaces in a model are assumed to be very small; small enough that simplifying approximations can be made on the contact evolution of the slipping motion. In an exemplary implementation, small slip implies that the relative displacement (slip) between the contacting surfaces in the tangential direction are small enough that it can be assumed that the contact area between the contacting surfaces does not significantly change, and the subsequent direction of slip remains in the plane of tangency of the initial point of contact between the surfaces.

In a typical implementation, a computer or computer system configured to check for linear assumption violations may be configured with a non-transitory computer-readable medium storing computer-readable instructions that, when executed by a computer processor, causes the computer processor to determine whether any linear assumption have been violated in performing a linear analysis as part of a computer simulation. There are a number of potential processes that may be implemented in this regard to make such determinations. In various implementations, the computer may be configured to store values that identify and help determine whether particular thresholds have been reached, such that a particular one (or more) of the applicable linear assumptions has been violated. In some implementations, the computer may be configured to solicit these values from a human user (e.g., through a graphical user interface) and/or may store a default set of values that are used to make such determinations about whether one (or more) of the applicable linear assumptions has been violated.

The computer is configured to present its determinations about whether one (or more) of the applicable linear assumptions has been violated to a human user, via a graphical user interface, in a manner consistent with that disclosed herein. The manner in which this information is conveyed is simple, organized, actionable, and intuitive. In some implementations, it may be presented in a manner that enables the human user to drill down and learn more about particular violations flagged by the computer. If a linear static structural simulation, for example, violates any (or all) of the foregoing mechanical assumptions by a sufficient degree, then the results of the simulation may be inaccurate. In some instances, if a linear static structural simulation violates a mechanical assumption, then different simulation software may produce quite different results for the same model and same set of simulated conditions. In those instances, any results produced, although available, would provide no meaningful insight into a product's or system's performance and any obtained results may be erroneous given that one or more (or all) of the fundamental assumptions were violated.

It is difficult, and sometimes impractical, for a user, even a sophisticated one, to manually assess linear assumptions in these circumstances because typical linear simulation applications (e.g., the Static Study and Linear Structural Validation apps) do not provide the user with complete control over solution output quantities or plot types that would be necessary to perform such an assessment. Simply put, in such instances, a user would find themselves in a difficult situation of having inaccurate results and no simple mechanism to understand that the results should not be trusted.

In a typical implementation, the systems and techniques disclosed herein provide an intuitive mechanism to convey to a user that a particular set of simulation results should or should not be trusted with respect to violating linear assumptions. This enables users, including non-expert users, to easily perform linear assumption checks thereby improving diagnostics for designers. Moreover, in a typical implementation, the system and techniques provide a single user interface dedicated to helping users, expert and non-expert alike, determine whether or not a set of simulation results are accurate with respect to linear assumptions. The solution targeted would rely on a number of solution quantities that already may be available for an expert user to request as output. Implementations of the systems and techniques disclosed herein may automatically assess whether any of the three key assumptions of linearity mentioned above, for example, are honored or violated by inspecting each part as well as a global assessment of the assembly. Implementations of the user experience disclosed herein deliver a tabular summary with Pass | Fail | Warning status indicators so a user, expert, or non-expert, can clearly and quickly understand whether simulation results honor linear assumptions.

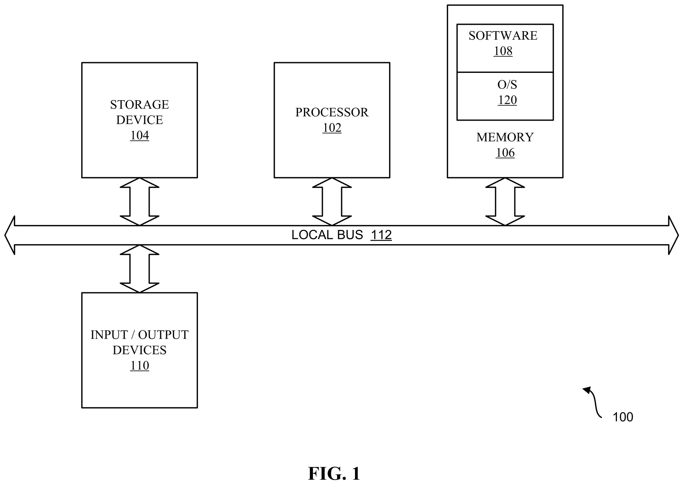

FIG. 1 is a schematic representation of a computer configured to execute the computer-implemented functionalities described herein, including to facilitate an understanding as to whether a particular set of simulation results should be trusted. The system 100 contains a processor 102, a storage device 104, a memory 106 having software 108 stored therein that defines the abovementioned functionality, input, and output (I/O) devices 110 (or peripherals), and a local bus, or local interface 112 allowing for communication within the system 100. The local interface 112 can be, for example, but is not limited to one or more buses or other wired or wireless connections. The local interface 112 may have additional elements, which are omitted for simplicity, such as controllers, buffers (caches), drivers, repeaters, and receivers, to enable communications. Further, the local interface 112 may include address, control, and/or data connections to enable appropriate communications among the aforementioned components.

The processor 102 is a hardware device for executing software, particularly that stored in the memory 106. The processor 102 can be any custom made or commercially available single core or multi-core processor, a central processing unit (CPU), an auxiliary processor among several processors associated with the present system 100, a semiconductor based microprocessor (in the form of a microchip or chip set), a macroprocessor, or generally any device for executing software instructions.

The memory 106 can include any one or combination of volatile memory elements (e.g., random access memory (RAM, such as DRAM, SRAM, SDRAM, *etc.*)) and nonvolatile memory elements (*e.g.,* ROM, hard drive, tape, CDROM, *etc.*). Moreover, the memory 106 may incorporate electronic, magnetic, optical, and/or other types of storage media. Note that the memory 106 can have a distributed architecture, where various components are situated remotely from one another, but can be accessed by the processor 102.

The software 108 defines functionality performed by the system 100, in accordance with the present invention. The software 108 in the memory 106 may include one or more separate programs, each of which contains an ordered listing of executable instructions for implementing logical functions of system 100, as described below. The memory 106 may contain an operating system (O/S) 120. The operating system essentially controls the execution of programs within the system 100 and provides scheduling, input-output control, file and data management, memory management and communication control and related services.

The I/O devices 110 may include input devices, for example, not limited to a keyboard, mouse, scanner, microphone, *etc.* Furthermore, the I/O devices 110 may also include output devices, for example but not limited to, a printer, display, etc. Finally, the I/O devices 110 may further include devices that communicate via both inputs and outputs, for instance but not limited to, a modulator/demodulator (modem; for accessing another device, system, or network), a radio frequency (RF) or other transceiver, a telephonic interface, a bridge, a router, or other device.

When the system 100 is in operation, the processor 102 is configured to execute the software 108 stored within the memory 106, to communicate data to and from the memory 106, and to generally control operations of system 100 pursuant to the software 108, as explained herein.

When the functionality of the system 100 is in operation, the processor 102 is configured to execute the software 108 stored within the memory 106, to communicate data to and from the memory 106, and to generally control operations of the system 100 pursuant to the software 108. The operating system 120 is read by the processor 102, perhaps buffered within the processor 102, and then executed.

When the system 100 is implemented in software 108, it should be noted that instructions for implementing the system 100 can be stored on any computer-readable medium for use by or in connection with any computer-related device, system, or method. Such a computer-readable medium may, in some embodiments, correspond to either or both the memory 106 or the storage device 104. In the context of this document, a computer-readable medium is an electronic, magnetic, optical, or other physical device or means that can contain or store a computer program for use by or in connection with a computer-related device, system, or method. Instructions for implementing the system can be embodied in any computer-readable medium for use by or in connection with the processor or other such instruction execution system, apparatus, or device. Although the processor 102 has been mentioned by way of example, such instruction execution system, apparatus, or device may, in some embodiments, be any computer-based system, processor-containing system, or other system that can fetch the instructions from the instruction execution system, apparatus, or device and execute the instructions. In the context of this document, a "computer-readable medium" can be any means that can store, communicate, propagate, or transport the program for use by or in connection with the processor or other such instruction execution system, apparatus, or device.

Such a computer-readable medium can be, for example, an electronic, magnetic, optical, electromagnetic, infrared, or semiconductor system, apparatus, device, or propagation medium. More specific examples (a non-exhaustive list) of the computer-readable medium would include the following: an electrical connection (electronic) having one or more wires, a portable computer diskette (magnetic), a random access memory (RAM) (electronic), a read-only memory (ROM) (electronic), an erasable programmable read-only memory (EPROM, EEPROM, or Flash memory) (electronic), an optical fiber (optical), and a portable compact disc read-only memory (CDROM) (optical). Note that the computer-readable medium could even be paper or another suitable medium upon which the program is printed, as the program can be electronically captured, via for instance optical scanning of the paper or other medium, then compiled, interpreted, or otherwise processed in a suitable manner if necessary, and then stored in a computer memory.

In an alternative embodiment, where the system 100 is implemented in hardware, the system 100 can be implemented with any or a combination of the following technologies: discrete logic circuit(s) having logic gates for implementing logic functions upon data signals, an application specific integrated circuit (ASIC) having appropriate combinational logic gates, a programmable gate array(s) (PGA), a field programmable gate array (FPGA), etc.

Structural simulations can be broadly characterized as linear or nonlinear analysis. In reality, all real-world problems are nonlinear, but the severity of the nonlinear behavior depends on many factors. As such, it is not uncommon for a nonlinear analysis to be simplified to a linear simulation, but it is generally up to the user (e.g., engineer/analyst/practitioner) to determine whether or not the simplified linear simulation accurately represents the solution to a particular problem. When a problem is simplified for linear analysis, it is inherently accompanied by several *linear* assumptions or approximations that must be honored in order for the solution to be accurate. In an exemplary implementation, these linear assumptions may include:
- All materials behave in a linear-elastic manner
   ∘ stress from loading < yield stress
   ∘ strains remain sufficiently small (material dependent limit)
      ▪ In some implementations, the small strain limit will be < ~5%
      ▪ In other implementations, the small strain limit may be lower than 5%
- All deformations are assumed to be small (infinitesimal strain theory)
   ∘ In simpler terms, the initial and final deformed shapes are nearly identical
- All rotations are assumed to be small
   ∘ Mathematically speaking: sin(theta) ≈ theta, cos(theta) ≈ 1, tan(theta) ≈ theta ; and/or
- All sliding contact behavior is tracked using the initial geometric configuration
   ∘ This fits with the assumption that initial and final configurations are nearly identical
   ∘ This implies that a node on Part-A does not slide beyond the boundaries of the element face it is contacting on Part-B

It is believed that no commercial finite element analysis (FEA) or simulation software available on the market today provides the ability for a user to quickly assess whether or not they have violated any linear assumptions. However, the methods for assessing whether these assumptions are violated (or not) are well documented in engineering literature, and an analyst/simulation expert would know how to manually perform this assessment. A manual assessment can be an arduous process, and it does generally require an in-depth understanding of the problem being solved and how to interpret FEA results and assess their validity with respect to linear assumptions. Stated otherwise, in the absence of a simulation expert or the core knowledge of how to perform a manual assessment of honoring linear assumptions, a non-expert user (designer or design engineer, for example) would not necessarily know how to perform this assessment. Worse yet, there exists no automated or semi-automated mechanism today that helps a non-expert user understand if their results are meaningful or meaningless due to violating linear assumptions. Simply put, when linear assumptions are not honored, solution results are still obtained, but the user does not receive any system feedback that their solution does not honor assumptions that are built-in to the simulation procedure.

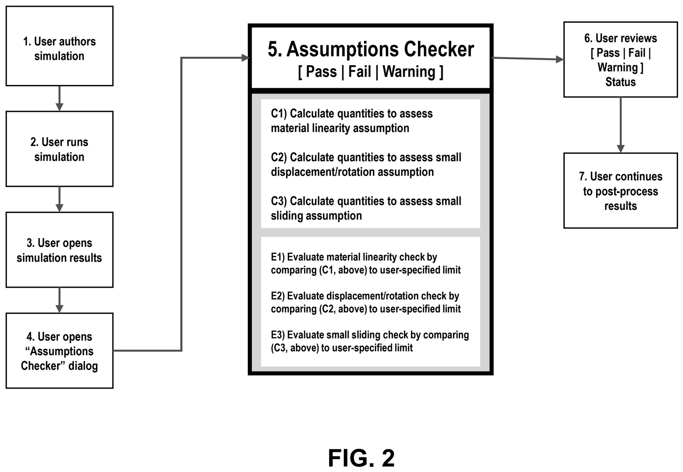

FIG. 2 is a flowchart of an implementation of a computer-implemented simulation and simulation review process.

According to the illustrated flowchart, the user (at step 1) authors the simulation. Authoring a simulation can involve a wide variety of activities. In a typical implementation, authoring a simulation may involve providing a computer-implemented model on which the simulation will be run, and collecting and preparing data to be input into the model to conduct the simulation.

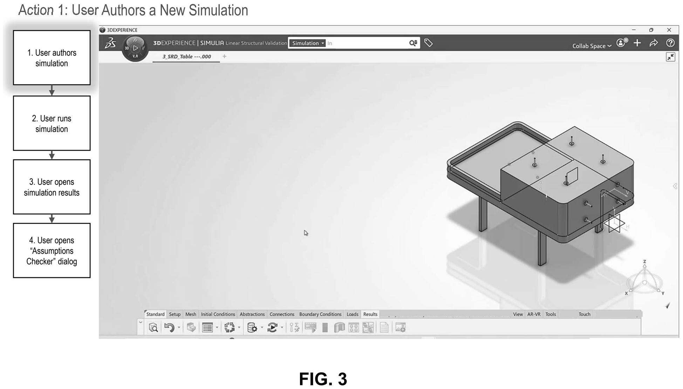

FIG. 3 shows an exemplary implementation of a screenshot that includes a three-dimensional depiction of a computer-based model in a computer-implemented simulation environment. The illustrated model has four legs that support a tabletop, a rim on an upper surface of the tabletop and a block on top of a portion of the tabletop. The illustrated simulation environment is provided by the SIMULIA^{®} software portfolio in the structures domain on the 3DEXPERIENCE^{®} platform provided by Dassault Systèmes. The screenshot shows a graphical user interface (GUI) with a workspace that shows the three-dimensional depiction of the modeled object and provides buttons in a ribbon across the bottom of the (GUI) that enable a user to access various simulation related functionalities. These include, in the illustrated implementation, standard functions, and functions related to setup, mesh, initial conditions, abstractions, connections, boundary conditions, loads, results, view functions, AR-VR, tools, and touch functions,. Of course, various other implementations may include a greater or fewer number of buttons, and associated functionalities or types of functionalities, and in some implementations, the specific buttons may differ than the ones shown.

Referring again to FIG. 2, next, according to the illustrated flowchart, the user (at step 2) runs the simulation. In actuality, once all the necessary data has been prepared and entered into or made available for entry into the model, the user initiates the simulation, and the computer (e.g., computer 100) executes the simulation. There are a variety of types of simulations the computer 100 may execute. In one example, the computer 100 may utilize simulation software, such as that provided by the SIMULIA^{®} software portfolio. In some implementations, the computer 100 may utilize Abaqus^{™} software, a structural simulation software product available in the SIMULIA^{®} software portfolio. In a typical implementation, the simulation conducted is a linear simulation, where certain assumptions need to be adhered to in order for the results to be reliable.

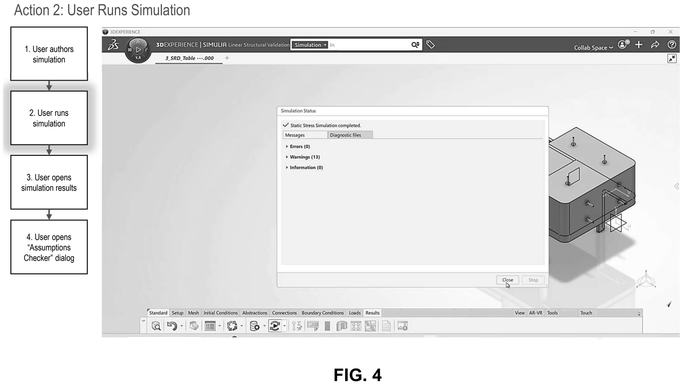

FIG. 4 shows an exemplary implementation of a screenshot that includes a pop-up window of the type that may appear, for example, after the computer 100 completes a simulation. The pop-up window identifies the status of the simulation, which, according to the illustrated implementation, is complete. The illustrated pop-up window further identifies that the simulation was a static stress simulation. Although not explicitly noted in the illustrated pop-up window, the static stress simulation is a linear static stress simulation and, as such, a set of the linear assumptions, as set forth herein, must have been adhered to during the simulation in order for the simulation results to be considered reliable. The illustrated pop-up window has two tabs including one for messages and one for diagnostic files. The messages tab is visible in the illustrated figure. The messages indicate that there are zero errors, thirteen warnings, and zero information. The pop-up window in the illustrated implementation is essentially superimposed on the screenshot of FIG. 3.

Next, according to the illustrated flowchart, the user (at step 3) opens or views the simulation results. Computer 100 may present the simulation results onscreen in any number of potential ways. In an exemplary implementation, the simulation results may be presented in a graphical user interface as a computer-generated image that is color-coded, or otherwise visually marked to reveal the results of the simulation on a three-dimensional depiction of the model. The color coding, in such implementations, may be accompanied by a key that indicates a characteristic and an associated value for that characteristic that the various colors on the three-dimensional depiction of the model represent. The information included in the results of the simulation generally depends on the aim of the simulation. In a simulation aimed at simulating structural behavior of a modeled part, for example, the information may include linear metrics related to structural phenomena such as stress and strain, yield, displacement, sliding, etc.

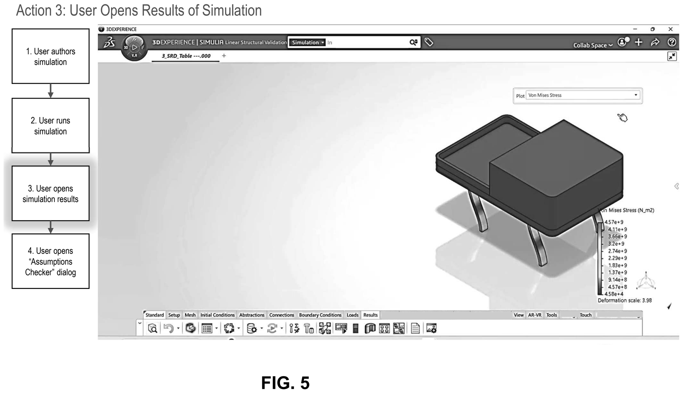

FIG. 5 depicts a Contour Plot of Von Mises Stress. It is indeed color-coded, but the contour plot shows *all* of the result quantities and not just a "Color-Coding" of Pass, Fail, or Warning. Von Mises stress is a measure of internal pressure, determined in this case via simulation, and used to determine if a material will yield or fracture. The units for von Mises stress are Newtons per square meter (N/m²). Units could also be lb/in², lb/ft², or any [Force Unit/Area Unit]. A key, which is immediately adjacent to the color-coded three-dimensional depiction of the computer-based model, identifies the meaning of each color in the color-coded three-dimensional depiction of the computer-based model. The key, in the illustrated implementation, is a vertical bar that has various colors along its length and that identifies, with number values right next to the bar, the value (in N/m²) represented by the associated color. Each location on the color-coded three-dimensional depiction of the computer-based model has a specific color that represents a specific value for von Mises stress represented by the color-coded bar key. The color coding in the illustrated image, for example, reveals that the legs portions of the three-dimensional computer-based model have higher values of von Mises stress than the tabletop, block, or rim.

Referring again to FIG. 2, next, according to the illustrated flowchart, the user (at step 4) opens an Assumptions Checker dialog. There are a variety of ways in which the user may perform this step. In a typical implementation, the user may select an onscreen user-selectable button to launch the Assumptions Checker dialog.

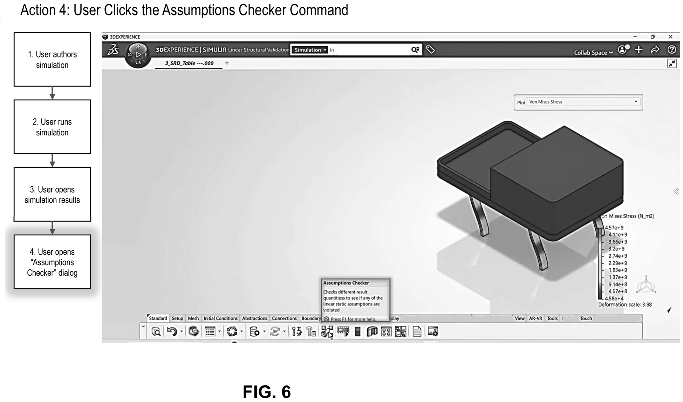

FIG. 6 shows an exemplary implementation of a screenshot that shows a cursor hovering over a user-selectable icon for activating the assumption checker functionalities. As indicated in the illustrated implementation, the computer 100, in response to the cursor being so positioned, displays a message that the assumption checker "checks different result quantities to see if any of the linear static assumptions are violated." Selecting (e.g., clicking on) the indicated icon launches the assumptions checker.

Referring again to FIG. 2, once launched, the assumptions checker, according to the illustrated implementation, the computer 100 (e.g., in response to a user prompt) initiates a process (see step 5) to determine whether any linear assumptions were violated in conducting the simulation and, if so, which linear assumptions were violated and which portions (e.g., which product structures, shapes, or bodies) were affected. There are a variety of ways in which the computer 100 may make these determinations. Based on the determinations, the computer 100 assigns a pass, fail, or warning status to each respective one or more of the simulation results (e.g., each of the one or more of the linear metrics) produced by the simulation and for each respective one of the one or more product structures, shapes, or bodies that make up the computer-implemented model used in the computer-implemented simulation.

Furthermore, according to the illustrated example, the computer 100 makes these determinations by calculating (5C1-5C3) various quantities to assess linearity assumptions and evaluating (5E1-5E3) a linearity check by comparing the calculated quantities against predefined limits. Based on the calculations and evaluations, the computer 100 (at step 5) assigns a status of pass, fail, or warning to each respective linear metric for each respective model element. More specifically, in the illustrated implementation, the computer 100 calculates, for each model element, quantities to assess material linearity assumptions (5C1), quantities to assess small displacement / rotation assumptions (5C2), and quantities to assess small sliding assumptions (5C3). Next, the computer 100 evaluates, again for each model element, a material linearity check (at 5E1) by comparing the calculated quantities to assess material linearity (from 5C1) against user-specified limits, a displacement/rotation check (at 5E2) by comparing the calculated quantities to assess small displacement / rotation assumptions (from 5C2) against user-specified limits, and a small sliding check (at 5E3) by comparing the calculated quantities to assess small sliding assumptions (from 5C3) against user-specified limits. Any user-specified limits may be entered into the computer 100 (and stored in memory), before, during, or after the simulation and may be done so in response to a prompt from the computer 100 soliciting the user to identify the associated limits. In some implementations, the computer system 100 may be preprogrammed to include the limits.

In some implementations, the limits define the boundaries of each range of values that correspond to passing, failing, and deserving of a warning. Depending on the outcome of the calculations (5C1-5C3) and evaluations (5E1-5E3), and the values of the calculated quantities relative to the user-specified limits, the computer 100 assigns a pass status, a fail status, or a warning status to each respective one of the assessed linear assumptions for each respective model element (e.g., product structure, shape, or body).

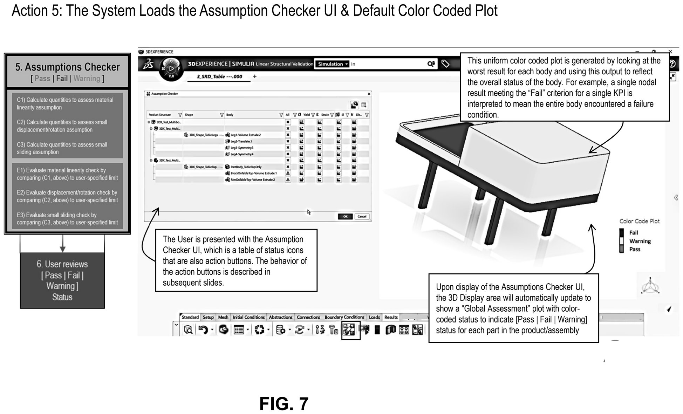

Next, in the illustrated flowchart, the user (at step 6) reviews the pass, fail, and warning statuses to assess violation of linear assumptions of the simulation results. In this regard, the computer 100, in a typical implementation, displays a variety of information related to a relatively simple, yet comprehensive, highly intuitive and interactive summary and presentation of the results of the assumption checker functionality (e.g., from step 5 in FIG. 2), an example of which is shown in FIG. 7.

Specifically, FIG. 7 shows an exemplary implementation of an assumption checker graphical user interface and a default color-coded plot depicted on a three-dimensional image of the computer-based model. The figure is annotated with a few descriptive notes as well.

The assumption checker user interface in the illustrated implementation is a table of status icons that are also action buttons (e.g., buttons that, if selected, cause the computer 100 to perform one or more actions). The specific behavior of the action buttons is described herein and represented in subsequent figures, described below.

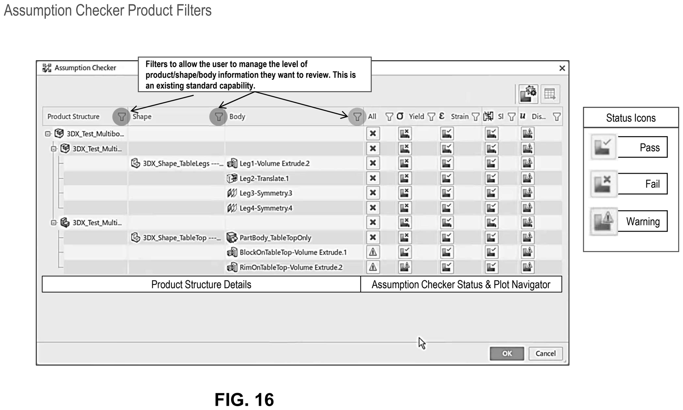

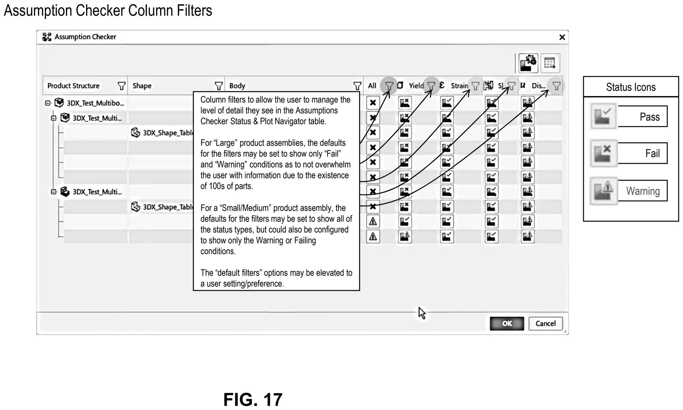

FIGS. 16 and 17 shows a zoomed-in, detailed and annotated view of the assumption checker user interface, like the one in FIG. 7. The table represented in the illustrated screenshots is organized into rows and columns, where each row corresponds to and represents a particular one of several model elements (e.g., product structures, shapes, and/or bodies) in a hierarchical model structure that make up the computer-based model, and each column corresponds to and represents a particular one of several linear metrics determined by a computer-implemented simulation involving the computer-based model.

The model elements in the illustrated example include the product structure "3DX_Test_Multibo...," which is composed of two other product structures: a first "3DX_Test_Multi...," and a second "3DX _Test_Multi...." The first "3DX_Test_Multi..." in the illustrated example is composed of shape "3DX_Shape_TableLegs." The second "3DX_Test_Multi..." in the illustrated example is composed of shape "3DX_Shape_TableTop." Shape "3DX_Shape_TableLegs" in the illustrated example is composed of bodies: "Leg1-Volume Extrude 2," "Leg2-Translate 1," "Leg3-Symmetry3," and Leg4-Symmetry4." Shape "3DX_Shape_TableTop" in the illustrated example is composed of bodies "PartBody_TableTopOnly," "BlockOnTableTop-Volume Extrude 1," and "RimOnTableTop-Volume Extrude 2." These model elements are presented in the illustrated table in a hierarchical fashion with indentation and relative positioning indicating the hierarchical relationships between elements. The linear metrics represented in the illustrated example include yield, strain, sliding (which is cut off), and displacement (which is cut off).

Each cell in the illustrated table is at an intersection of one of the rows (model elements) and one of the columns linear metrics. Each cell is populated with one status icon that identifies a status (e.g., pass, fail, warning) for a corresponding one of the linear metrics for a corresponding one of the model elements. Specifically, each status icon provides a visual indication as to whether the computer-implemented simulation involving the computer-implemented model and that produced the corresponding results violated any linear analytical assumptions. In general terms, a pass status indicator indicates that the computer 100 determined that no analytical assumptions were violated, a fail status indicator indicates that the computer 100 determined that at least one of analytical assumptions was violated, and a warning status indicator indicates that the computer 100 determined that one or more of the linear assumptions may have been violated and/or may have impacted the results of the computer-implemented simulation at least with respect to the corresponding linear metric for the corresponding model element.

The annotations on the figure indicate that in some implementations, for a given column linear metric in the table, the computer 100 performs the necessary calculations to determine a condition (or status) for every cell, iterating over every row. Eventually, the computer 100 calculates all of the conditions (statuses) for all of the rows. The computer 100 may then, for each row (model element), find the "worst case" condition (status) for that row.

In the top row of the illustrated example, the yield entry, used as the metric for linear material behavior, is the "worst case" condition (status) for that row, which corresponds to the model element labeled "3DX_Test_Multibo...." The yield entry is the "worst case" condition (status) because the cell that corresponds to the yield entry is populated with a fail status icon, whereas the cells that correspond to strain and sliding are populated with pass status icons and the cell that corresponds to displacement is populated with a warning status icon. The yield entry in this example is deemed the "worst case" because fail is deemed to be worse than pass and warning. In general, pass is the "best case," fail is the "worst case," and warning is between the two.

The computer 100 then, according to the annotations in the figure, makes the status of the "All" column the "worst case" condition (status) when looking across the row. In the example of the top row in the illustrated figure, discussed above, the yield entry was deemed the "worst case" condition (status), therefore, the "All" column gets a fail status icon. If a particular row of linear metric status icon entries has no worse than a warning status icon, then the "All" column for that row would get a warning status icon. If a particular row of linear metric status icon entries has all pass status icons, then the "All" column for that row would get a pass status icon. In an exemplary implementation, the computer 100 may be configured to scan a row to look for any fail statuses. If any fail statuses are identified, the computer 100 assigns a fail status icon to the "All" column for that model element. If no fail statuses are identified, then the computer 100 may scan the row to look for any warning statuses. If any warning statuses are identified, then the computer 100 assigns a warning status icon to the "All" column for that model element. If no warning statuses are identified in the scan, then the computer 100 assigns a pass status icon to the "All" column for that model element. Thus, the "All" column gives the user a quick snapshot view of the worst degree of reliability that applies to a particular model element in the simulation results and thus represents a comprehensive status icon for that particular model element. Of course, each column of the tabular report produced by the Assumption Checker tool provides detailed insight into the quality of the simulation results based on the linear assumption being checked, but the "All" column, is a roll-up summary across a given row; the worst-case status is reflected as the status in the "All" column. As another example, if the yield, strain, and displacement assumptions are honored (pass), but the sliding status is a warning (yellow), then the "All" column will reflect a value of "warning."

Referring again to FIG. 7, the color-coded plot on the three-dimensional depiction of the computer-based model is generated by the computer 100 identifying the "worst case" condition (status) for any linear metric for each model element (e.g., body) and color coding the depiction accordingly. Thus, in a typical implementation, the color coding of the three-dimensional depiction corresponds to the status icons in the "All" column of the tabular assumption checker UI. In an exemplary implementation, any model element (e.g., body) whose "All" column status is failed may be displayed in red, any model element whose "All" column status is warning may be displayed in yellow, and any model element whose "All" column status is pass may be displayed in green. A color code plot key, identifying the meanings of the various colors applied in the color-coded plot, is provided to the right side of the three-dimensional depiction.

Thus, as noted in the figure, the uniform color-coded plot is generated by looking at the worst result for each body and using this output to reflect the overall status of the body. For example, a single nodal result meeting the "fail" criterion for a single linear metric may be interpreted by the computer 100 to mean that the entire body encountered a failure condition, and the coloring in the depiction would reflect just that. Moreover, in a typical implementation, as soon as the computer 100 displays the assumption checker user interface, the three-dimensional display area (the area that contains the three-dimensional depiction) automatically updates to show a global assessment plot with color-coded status to indicate a pass, a failure, or a warning status, as appropriate, for each respective part in the illustrated product/assembly.

In a typical implementation, the systems and techniques disclosed herein, including the screenshot and associated functionalities represented in FIG. 7, help focus the user's attention on areas of greatest concern, which is a key usage pattern of the Assumption Checker functionalities. The application in question aims to provide out-of-the-box (OOTB) expert-level guidance based on assessing results quantities and comparing them against pre-specified limits, which, in some instances, may be limits that are commonly found in engineering literature. The global assessment plot may be displayed as a color-coded plot based on three status indicators: 1) regions of the solution results that do not violate linear assumptions are considered passing and will be assigned a default color of green, 2) regions of the solution results that clearly violate linear assumptions are considered failing and will be assigned a default color of red, and 3) regions where solution results are questionable with respect to honoring linear assumptions are considered warning regions and will be assigned a default color of yellow. In some implementations, when the Assumption Checker tool is first accessed by the user, the 3DViewing area will render every part and/or body in the assembly as Red, Yellow, or Green to provide a top-level "global" status indicator that clearly guides the user to regions of their model where they should more carefully inspect results. Each intersection of a row and column in the tabular Assumption Checker UI, results in a unique selection of product scope (e.g., model element(s)) and result quantity to plot. The rows in the UI provide a tree-table view of the product structure (e.g., model element(s)) that may be analyzed by the user.

The screenshot in FIG. 7 shows an example of an assumption checker UI and a corresponding default color-coded plot. The default color-coded plot in the illustrated implementation is a global assessment plot.

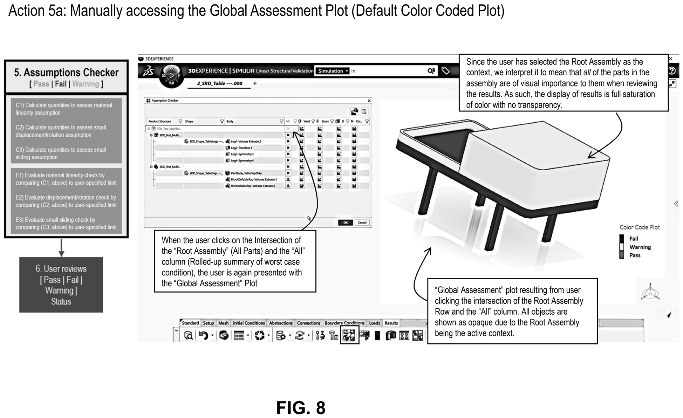

A global assessment plot can be thought of as the intersection of the Assembly Row (row 1) and the All Column, as represented in FIG. 8 (see, e.g., the shaded selection in the tabular Assumption Check UI). Anytime the user clicks on the dedicated button at this intersection of the row and column, the global assessment plot, as shown in FIG. 8, will be generated by the computer 100. This is the same color-coded plot that appeared, by default, in the FIG. 7 screenshot. As noted in the figure, when the user clicks on the intersection of the root assembly ("3DX_Test_Multibo..."), corresponding to all parts and the "All" column (a rolled up summary of worst case conditions / statuses for linear metrics), the computer 100 displays a global assessment plot that has the same appearance as the default color-coded plot from the FIG. 7 screenshot.

Since the user, in the FIG. 8 scenario, has selected the root assembly as the context, the computer 100 interprets and responds to the selection as if all parts of the assembly are considered to be of visual importance to the user in regard to reviewing the results. As such, the three-dimensional depiction of the modeled object is shown fully saturated with color (e.g., red, yellow, and/or green), with no portions being transparent. As noted in the figure, the resulting global assessment plot resulting from the user clicking on the intersection of the root assembly and the "All" column shows all objects as opaque due to the root assembly having been flagged as the active context for viewing. Anytime the root assembly has been flagged as the active context for viewing, all of the objects from the modeled object are shown as opaque and fully saturated with color to indicate associated statuses.

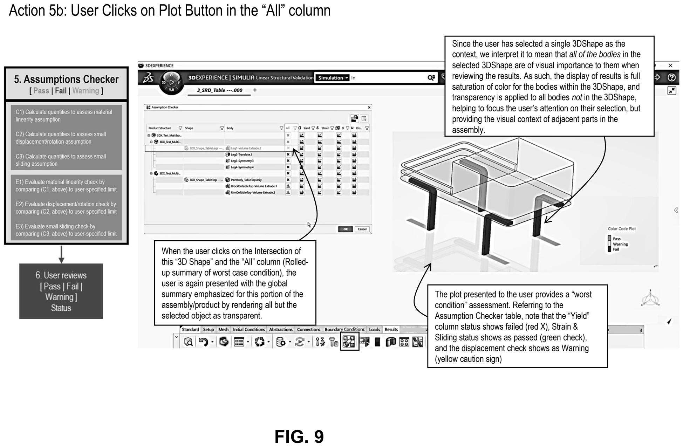

If the user were to click the intersection of the 3^{rd} row (i.e., legs sub-region of the product assembly) and the All column, as shown in FIG. 9, for example, the resulting color-coding plot shows the color-coded status in full color saturation (e.g., no transparency) on the legs of the three-dimensional depiction of the modeled object, while all other regions of the depiction are rendered transparent but also, in a typical implementation, with the accompanying status color coding. Thus, as noted in the figure, when the user clicks on the intersection of the indicated 3D shape and the "All" column (the rolled up summary of worst case conditions), the computer 100 presents a global summary (e.g., illustrating the full computer-based model) emphasized for this portion of the assembly / product by rendering all but the selected model element(s) as transparent. Since the user, in the FIG. 9 scenario, has selected a single 3DShape as the context, the computer 100 interprets the user's selection to mean that all of the bodies in the selected 3DShape are of visual importance to the user in reviewing reliability of the simulation results. As such, the three-dimensional depiction of the computer-based model shows the bodies within the selected 3DShape in full saturation color, whereas the rest of the bodies, not included in the selected 3DShape, are displayed with transparency yet, still, in a typical implementation, color-coded. This helps focus the user's attention on his or her selection, while also providing full visual context of the adjacent parts in the depicted computer-based model. The plot thus presented provides the user with a "worst condition" assessment. Referring to the assumption checker table, note that the status icon in the "Yield" column (representing the linear material approximation metric), shows failure (i.e., a red x), strain and sliding show a passing (green check), and the displacement check shows as warning (yellow caution sign).

The user may, of course, click on a button anywhere in the assumption checker UI table. In one example, the user may click on or select a status icon for the tabletop only model element in the yield linear metric column.

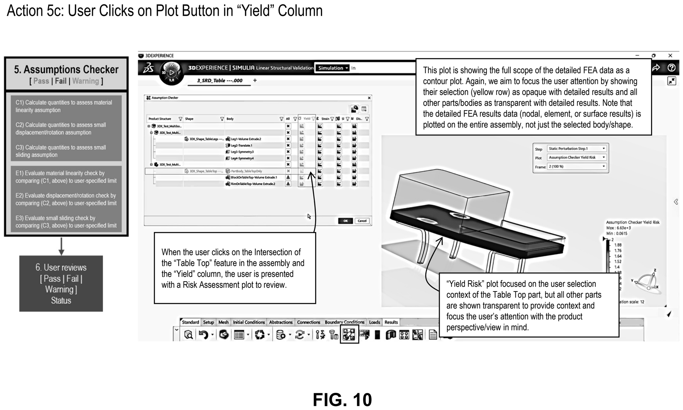

Navigating the individual linear assumption, or linear metrics, columns, provides a behavior similar to the global assessment plot with at least one unique difference; when the button at the intersection of a row and column is clicked, the computer 100 generates a results contour plot (also known as a field plot) for the specific linear metric. For the example shown in FIG. 10, the user has clicked on the intersection of the Tabletop region and the Yield column (representing the linear material approximation metric). The resulting plot provides a fully saturated (no transparency) plot of yield risk (factor of safety) for the tabletop; for all other regions of the model, transparency is applied to the detailed contour plot in order to provide the user with the full context of the assessed linear metric, but with the part/region (row) the user has selected as the main focus. The plot is generated, in some implementations, by comparing a magnitude of the stress to a known material input quantity named the Yield Stress. In a typical implementation, the user must provide or designate yield stress as an input to the computer as part of a material description in order for this comparison to occur.

As noted in FIG. 10, when the user clicks on an intersection of the Tabletop feature in the assembly and the yield column, the computer 100 displays a risk assessment plot to review. The plot shows the full scope of detailed finite element analysis (FEA) data as a contour plot in the illustrated example. The illustrated plot focuses the user's attention on the selected Tabletop by showing the user's selection (shaded row) as opaque with detailed results and all other parts and/or bodies being displayed as transparent. In various implementations, the detailed FEA results data (nodal, element, or surface results) may be plotted on just the selected body / shape, or on the entire assembly (e.g., the entire depiction of the computer-based model). The yield risk plot in the illustrated example focuses on the user selection context of the Tabletop part (with two areas specifically identified as being of particular interest) but all other parts are shown transparent to provide context and focus the user's attention with the product perspective / view in mind.

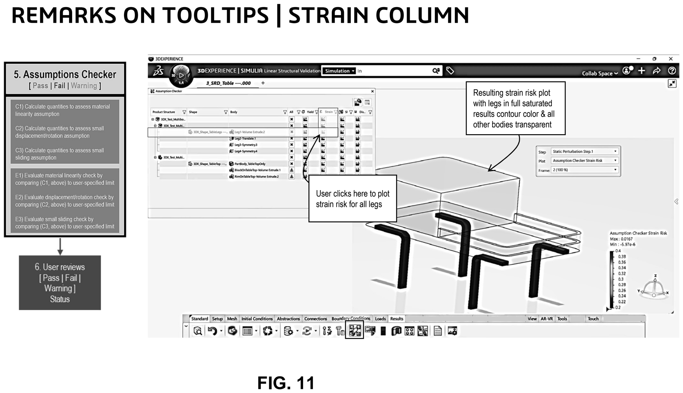

FIG. 11 shows an example of a screenshot that includes the assumption checker tabular UI (with a particular selection having been made) and a corresponding and exemplary strain assessment plot for the table legs. In a typical implementation, the strain assessment plotting and interactive behavior is similar to the behavior for the yield column, with an exception that computer 100 is here comparing a magnitude of the strain to a known limit, typically defined internal to the software system. The user does not generally have control over this known limit. As noted in the figure, the user clicks at the indicated position in the tabular UI to produce the displayed image. The user's selection is for strain as it relates to all legs. This results in a strain risk plot, as shown, with legs shown in full saturation and color-coded, and all other bodies shown transparent.

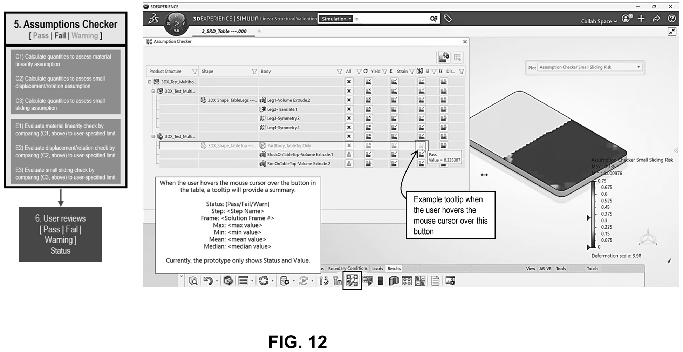

FIG. 12 is a screenshot that shows an example of a screenshot that includes the tabular assumption checker UI and a small-sliding plot for the Tabletop alone. Specifically, as indicated, when the user hovers a mouse cursor over the indicated button in the table, the computer 100 shows a tooltip that provides a summary of status (pass/fail/warn), step (step name), frame (solution frame #), max (maximum value), min (minimum value), mean (mean value), and median (median value). Currently, the prototype, which is depicted only shows the status and value (e.g., in the three-dimensional depiction of the tabletop).

As mentioned elsewhere herein, small-sliding is a linear approximation to the contact behavior that results in a significant simplification in the solution complexity. However, if the small-sliding approximation is not used judiciously, a user can end up producing results that may look physical in nature but would be inaccurate due to violating the fundamental assumption. Physically, the small-sliding approximation means that any deformation experienced by the structure does not result in significant deformation of any geometric surfaces. Stated differently, as the surface distorts, the distorted surface shape and orientation are *not* accounted for in the contact solution. This implies that the original and final surface configurations must remain nearly identical for this assumption to hold true.

The small-sliding approximation can be described using a fairly simple example. Imagine a perfectly square plate in space (Part-A); the edges of the plate form the natural boundary. Now imagine a point at the center of the plate, which represents a finite element *node* from an adjacent body (Part-B). The small sliding approximation assumes that the *node* on Part-B will not slip/slide such that it moves beyond the initial boundary of the plate. When the node moves beyond the boundary, the small-sliding approximation/assumption is violated. This description is an *example* of a case that would violate the small-sliding assumption, but it is not the only case in which the small sliding assumption can be violated. Take another example: Imagine a square plate oriented on a plane in space. Now imagine a ball rolling on that plate. The small sliding approximation assumes that as the ball rolls on that plate, the plate remains planar and its orientation remains exactly the same as it did with respect to the original plane. If the plate deformed (became curved) or rotated outside of the original plane, the small sliding assumption would be violated. More generally, the small sliding assumption means that the software is looking at the point of contact of one body against the surface of another at the beginning of the simulation. The software computes the plane of tangency on the surface at the points of contact and assumes that a given point in contact will always slide in that tangency plane. This assumption is true if the extent of sliding is small enough that the tangency plane remains a good approximation for the actual surface geometry during the course of the simulation.

FIG. 12 shows an example of the small-sliding assessment plot. This image intentionally does not show adjacent parts rendered with transparency in order to provide the reader with a visual comparison of how default plots typically appear in the current software system (**3D**EXPERIENCE). It should be noted that the small-sliding assessments will display in a manner that is consistent with the other assumption risk/linear metric plots. It is worth noting that manually creating this type of plot, if even possible, typically would require expert-level knowledge of solution quantities to assess whether sliding is sufficiently "small."

In a typical implementation, the computer 100 is able to generate a plot of displacement assessment.

In a typical implementation, the usability and display of this sort of plot would be consistent with the yield (linear material), strain, and slip columns. The displacement assessment plot may help the user understand whether or not displacement and rotation magnitudes can be considered as small. To perform this assessment, the computer may rely on functionalities in the SOLIDWORKS^{®} computer software. The general approach is to create what is referred to as a normalized displacement plot, which may be computed as the ratio of the displacement solution to a characteristic length, and may be present in SOLIDWORKS^{®} computer software. It is worth noting that manually creating this sort of plot, if at all possible, would likely require expert-level knowledge of solution quantities to assess whether displacements and rotations can be considered sufficiently "small."

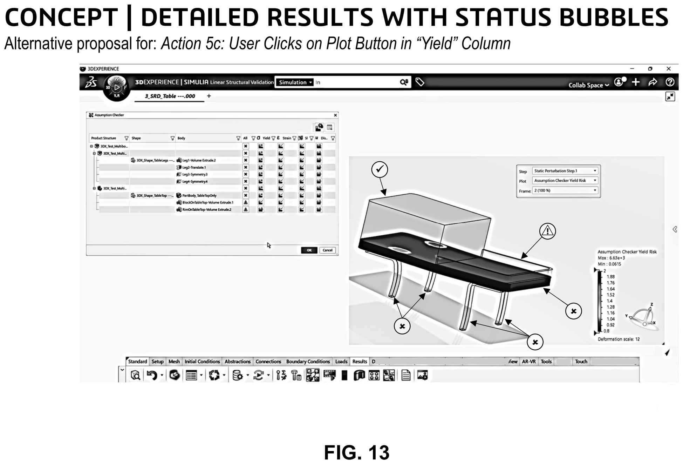

In some implementations, the computer 100 is configured to produce and display Global Status Annotations (e.g., showing detailed results with status bubbles). This additional UI concept provides a capability where the user is able to clearly understand the global pass/fail/warning status while also navigating a rich contour plot for a given assumption assessment, such as the Yield Assessment Plot. FIG. 13 shows an example of this kind of screenshot demonstrating the utility of adding global status annotations to the rendered Assumption Assessment Plot. The intent is as follows: 1) A user's attention is first focused on the Assumption Checker UI, where they are interacting with the tree-table view of their product/part, along with pass/fail/warning status indicators for each plot. 2) The user clicks one of the buttons at the intersection of a row and column that is *not* the All column. 3) The associated Assumption Assessment Plot (e.g., risk plot) is rendered as previously described (selected row object has no transparency, all other bodies are transparent). 4) When the user renders the plot, it is assumed the user will change their visual focus from the UI dialog (left side of FIG. 13) to the 3D display area (right side of FIG. 13). In doing so, the user may have lost the context as to whether their selected region of interest (row) had a pass, fail, or warning status. 5) It is assumed that by providing 3D annotations with pass/fail/warning indicators will help provide valuable "global" context to the user while also interrogating the results.

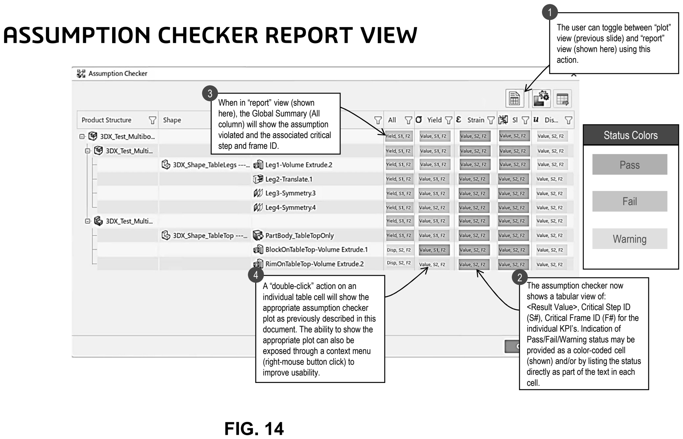

In some implementations, the computer 100 is configured to produce an assumption checker report view, an example of which is shown in FIG. 14.

With regard to the assumption checker report view, it has been recognized that some users may want to navigate the assumption checker information by reviewing the key step, frame, and result quantity information in a tabular form rather than with interactive plotting. FIG. 14 provides a visual example of this alternative view of the assumption checker. In some implementations, the user may toggle between the Report and Plot View at their convenience. A user may wish to capture the output/results of the assumption checker. Once a user has performed a detailed assessment of the linear assumption checks, the user may wish to export the detailed tabular results to a spreadsheet of **3D**EXPERIENCE Platform managed document, for example, consistent with existing functionality for results "Field Export." This would be facilitated though the upper-right most button FIG. 14.

As noted in the figure, the user can toggle between Plot view and Report view using the flagged button in the upper right corner of the screen. The same button may be provided on the corresponding Plot view screen. The assumption checker, in the illustrated screenshot shows a tabular view of information including result values, critical step IDs (S#), and critical frame IDs (F#) for the individual linear metrics. Indication of pass/fail/warning statuses may be provided as color-coded cells in the illustrated implementation and/or by listing or indicated the status directly as part of the text in each cell. When in Report view, the global summary (All column) shows the assumption violated and the associated critical step and frame IDs.

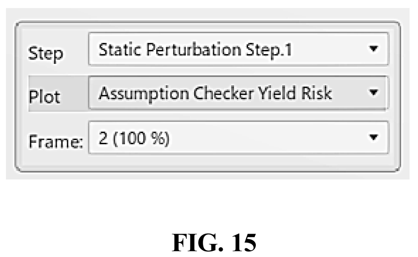

It is worth noting that the images in this document show a Step, Plot, and Frame selector UI component for results navigation, as shown in FIG. 15. However, in an exemplary implementation, the only mechanism for a user to access the plots that are automatically generated by the assumption checker is to use the Interactive Plot view of the Assumption Checker UI, as shown in FIG. 14. In a typical implementation, this facilitates provide clear visual context and guidance to where a non-expert user should focus their attention when reviewing the results of a linear analysis.

FIG. 16 shows that the tabular assumption checker UI has filters that allow the user to manage the level of product/shape/body information they want to review.

FIG.. 17 shows that the tabular assumption checker UI has filters for the linear metric columns. As noted in the figure, the column filters allow the user to manage the level of detail the computer 100 displays in the assumption checker status and plot navigator tables, discussed herein. For large product assemblies, for example, the defaults for these filters may be set to show only fail and warning conditions / statuses. This may minimize the likelihood of overwhelming the user with information due to the existence of potentially hundreds of different parts. For a smaller or medium sized product assembly, the defaults for these filters may be to show all of the status types but could also be configured to shown only the fail and warning conditions / statuses. The default filters options may be determined by a user setting / preference or may be preprogrammed into the software.

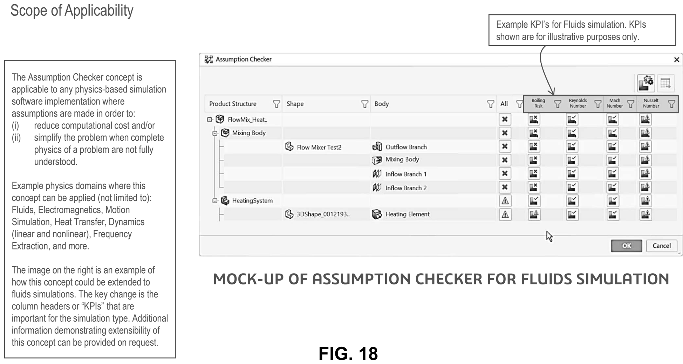

FIG. 18 shows that the assumption checker concepts can be applied to other types of simulations. Specifically, in the illustrated example, the tabular assumption checker UI (which may be implemented with and operational within a system just like the ones described herein) is for a fluid simulation. As noted in the figure, the assumption checker concepts are applicable to any physics-based simulation software implementation where assumptions are made in order to gain some advantage (e.g., reducing computation cost and/or simplifying the problem when complete physics of a problem are not fully understood, etc.). Examples of physics domains where these concepts may be applied include, but are not limited to fluids, electromagnetics, motion simulation, heat transfer, dynamics (linear and nonlinear), frequency extraction, and more. The illustrated table shows linear metrics for fluid simulations, which, according to the illustrated example, include boiling risk, Reynolds number, Mach number, and Nusselt number. These are linear metrics that may be considered important for these types of simulations.

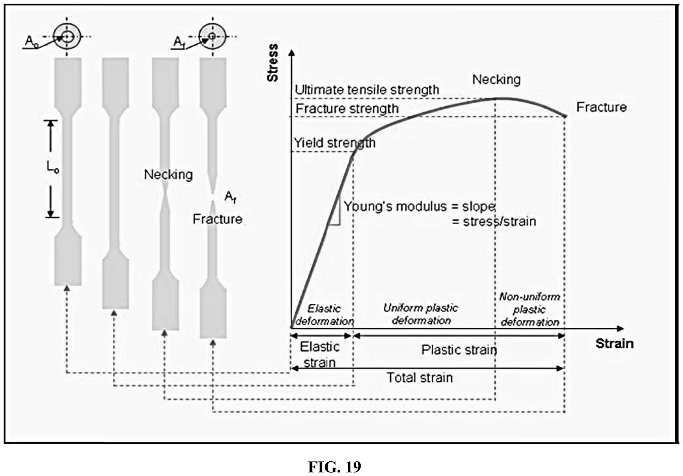

FIG. 19 shows an exemplary object at different stages of being exposed to stress and strain over time and a plot of stress and strain adjacent to the object.

The object is a real world object being exposed to real world stress and experiencing real world strain as a result of the applied stress. Alternatively, the object may be represented by a computer-implemented model that is exposed to stress in a computer-implemented simulation to reveal a strain associated therewith by application of a computer-implemented analysis. The object has tabs at opposite ends connected to one another with a narrow neck having a starting length (L₀) and a starting cross-sectional area (A₀). The sequence of object images shows that the narrow neck stretches over time, eventually experiencing necking, and then (when the cross-sectional area shrinks to a fracturing area (A_{f}) fractures. The relationship between applied stress and strain that the object experiences is mapped to the plot of stress vs. strain. From that plot, it can be seen that in the first image, the object may experience elastic strain and elastic deformation. During this phase, Young's modulus is equal to the slope of the stress-strain curve, as indicated in the plot. This continues until the stress applied reaches a yield strength of the object (e.g., the neck portion of the object), beyond which the object begins to experience uniform plastic deformation. This continues until the applied stress reaches the ultimate tensile strength of the object (e.g., the neck portion thereof), where the necking begins. After that, the object experiences non-uniform plastic deformation and the stress begins to drop while strain continues to grow until the object eventually fractures. Linear analysis is effective at predicting the behavior of the object from a stress-strain perspective in the elastic deformation/elastic strain portion of the stress-strain curve because, as shown, the stress-strain curve in that portion of the plot is substantially linear.

A number of embodiments of the invention have been described. Nevertheless, it will be understood that various modifications may be made without departing from the spirit and scope of the invention.

For example, although certain inputs and components to the systems and techniques disclosed herein may be provided by certain expert apps, a user of Static Study or Linear Structural Validation would not have the data or plots necessary to assess all three assumptions of linearity.

The assumptions checker may rely on a number of existing simulation output quantities and plots to assess the pass | fail | warning statuses. In an exemplary implementation, the system may rely, at least in part, on the following: a CSL_Normalized output in Abaqus, existing SOLIDWORKS Simulation methodologies to assess large deformation, as documented, for example, on the SOLIDWORKS website (e.g., at help.SOLIDWORKS.com/2013/english/SOLIDWORKS/cworks/c_large_displacement_solution. htm?verRedirect=1).

The systems and techniques disclosed herein relate to simulation. Some of the implementations disclosed herein relate specifically to linear structural analysis. Automatically assessing simulation results to understand whether assumptions are violated is extensible to all other physics disciplines (fluids, electromagnetics, etc.) for linear and nonlinear analysis. Any simulation using, for example, a 3DS product could inherit a similar assumption checker. A basic premise is to automatically check simulation results against known limits of the assumptions and evaluate whether or not the simulation results honor said assumptions. These approaches could also be extended to assess fundamental assumptions involved with other physics simulation domains, such as fluid dynamics and electromagnetics.

The solutions disclosed herein provide a non-binary assessment and will assess the violation of linear assumptions using [Pass | Fail | Warning] status indicators. The information provided to the user will help them specifically identify whether they have violated any assumptions of linearity as part of the assessment of results accuracy. It should be noted that if a given simulation passes all linear assumption checks pass, it is still the user's responsibility to perform mesh convergence studies, assess stress singularities, etc. in order to assess the reliability and accuracy of the results.

In various implementations, once a particular simulation metric has been identified as violating (or potentially violating) a linear assumption, the user may have various options. These may include accepting the violation, modifying the object, adjusting the parameters (e.g., applied loading or boundary conditions) in the linear analysis, running a nonlinear analysis at least on the affected element of the model (or on the model in its entirety), etc.

In various implementations, computer components disclosed herein (e.g., applications, design tools, etc.) can be implemented by one or more computer-based processors (referred to herein as a processor) executing computer-readable instructions stored on non-transitory computer-readable medium to perform the associated computer-based functionalities (e.g., the functionalities disclosed herein attributable to a computer). The one or more computer-based processors can be virtually any kind of computer-based processors and can be contained in one housing or distributed at different locations, and the non-transitory computer-readable medium can be or include any one or more of a variety of different computer-based hardware memory / storage devices either contained in one housing or distributed at different locations.

Certain functionalities are described herein as being accessible or activated by a user selecting an on-screen button or the like. This should be construed broadly to include any kind of visible, user-selectable element or other user interactive element.

The systems and techniques disclosed herein can be implemented in a number of different ways. In one exemplary implementation, the systems and techniques disclosed herein may be incorporated into the SIMULIA^{®} computer program available as part of the 3DEXPERIENCE^{®} platform from Dassault Systèmes. In various implementations, the systems and techniques can be deployed otherwise.

Various aspects of the subject matter disclosed herein can be implemented in digital electronic circuitry, or in computer-based software, firmware, or hardware, including the structures disclosed in this specification and/or their structural equivalents, and/or in combinations thereof. In some embodiments, the subject matter disclosed herein can be implemented in one or more computer programs, that is, one or more modules of computer program instructions, encoded on computer storage medium for execution by, or to control the operation of, one or more data processing apparatuses (e.g., processors). Alternatively, or additionally, the program instructions can be encoded on an artificially generated propagated signal, for example, a machine-generated electrical, optical, or electromagnetic signal that is generated to encode information for transmission to suitable receiver apparatus for execution by a data processing apparatus. A computer storage medium can be, or can be included within, a computer-readable storage device, a computer-readable storage substrate, a random or serial access memory array or device, or a combination thereof. While a computer storage medium should not be considered to be solely a propagated signal, a computer storage medium may be a source or destination of computer program instructions encoded in an artificially generated propagated signal. The computer storage medium can also be, or be included in, one or more separate physical components or media, for example, multiple CDs, computer disks, and/or other storage devices.

Certain operations described in this specification (e.g., aspects of those attributable to a computer) can be implemented as operations performed by a data processing apparatus (e.g., a processor / specially programmed processor / computer) on data stored on one or more computer-readable storage devices or received from other sources, such as the computer system and/or network environment described herein. The term "processor" (or the like) encompasses all kinds of apparatus, devices, and machines for processing data, including by way of example a programmable processor, a computer, a system on a chip, or multiple ones, or combinations, of the foregoing. The apparatus can include special purpose logic circuitry, e.g., an FPGA (field programmable gate array) or an ASIC (application specific integrated circuit). The apparatus can also include, in addition to hardware, code that creates an execution environment for the computer program in question, for example, code that constitutes processor firmware, a protocol stack, a database management system, an operating system, a cross-platform runtime environment, a virtual machine, or a combination of one or more of them. The apparatus and execution environment can realize various different computing model infrastructures, such as web services, distributed computing, and grid computing infrastructures.

While this specification contains many specific implementation details, these should not be construed as limitations on the scope of any inventions or of what may be claimed, but rather as descriptions of features specific to particular embodiments of particular inventions. Certain features that are described in this specification in the context of separate embodiments can also be implemented in combination in a single embodiment. Conversely, various features that are described in the context of a single embodiment can also be implemented in multiple embodiments separately or in any suitable sub-combination. Moreover, although features may be described above as acting in certain combinations and even initially claimed as such, one or more features from a claimed combination can in some cases be excised from the combination, and the claimed combination may be directed to a sub-combination or variation of a sub-combination.

Similarly, while operations may be described herein as occurring in a particular order or manner, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Other implementations are within the scope of the claims.

## Claims

1. A computer-based method comprising:
- receiving data that indicates whether each respective one of a plurality of linear metrics produced by a linear analysis of a computer-implemented model in a computer-implemented simulation is accurate with respect to linear assumptions in the model;
- displaying, on a graphical user interface, a plurality of status icons, wherein each status icon is visually associated with a corresponding one of the plurality of linear metrics and a corresponding one of a plurality of model elements that make up the computer-implemented model, wherein each of the plurality of model elements is displayed on the graphical user interface in a manner that represents a hierarchical model structure of the model elements within the computer-implemented model,
wherein each status icon provides a visual indication of whether the corresponding one of the plurality of linear metrics for the corresponding one of the plurality of model elements produced by the linear analysis of the computer-implemented model in the computer-implemented simulation violated any of the linear analytical assumptions.

2. The computer-based method of claim 1, wherein displaying, on the graphical user interface, the plurality of status icons comprises displaying the hierarchical model structure as an onscreen visual representation with a plurality of the model elements arranged in an arrangement that is nested in accordance with their respective relationships within the hierarchical model structure, and wherein each model element represents a product structure, a shape, or a body in the computer-implemented model.

3. The computer-based method of claim 2, wherein the computer-implemented model comprises one or more of the product structures, wherein each of the product structures comprises one or more of the shapes, and wherein each of the shapes comprises one or more of the bodies.

4. The computer-based method of claim 2 or 3, wherein the status icons are arranged in an array with each respective one of the status icons being visually associated with the corresponding one of the plurality of linear metrics and the corresponding one of the plurality of model elements from the computer-implemented model by virtue of a row and column location of that status icon within the array.

5. The computer-based method of any one of claims 2 to 4, further comprising:
enabling a user to select any one or more of the status icons displayed on the graphical user interface; and
in response to the user selecting a particular one of the status icons, displaying, on the graphical user interface, a three-dimensional visual representation of at least the product structure, shape, or body that corresponds to the selected status icon.

6. The computer-based method of claim 5, wherein the three-dimensional visual representation of at least the product structure, shape, or body that corresponds to the selected status icon has a visual appearance that reflects whether the selected status icon represents a violation of any of the linear analytic assumptions.

7. The computer-based method of claim 6, wherein each of the status icons is either a pass status icon, a fail status icon, or a warning status icon,
preferably further comprising:
assigning a pass status icon to a first one of the linear metrics for a first one of the model elements in response to a determination that the computer-implemented simulation that produced the first one of the linear metrics did so without violating any of the linear analytical assumptions;
assigning a fail status icon to a second one of the linear metrics for a second one of the model elements in response to a determination that the computer-implemented simulation that produced the second one of the linear metrics did so in a manner that violated one or more of the linear analytical assumptions,
wherein the pass status icon has a different visual appearance on the graphical user interface than the fail status icon,
more preferably further comprising:
assigning a warning status icon to a third one of the linear metrics for a third one of the model elements in response to a determination that the computer-implemented simulation that produced the third one of the linear metrics did so in a manner that did not satisfy criteria for assignment of a pass status icon or a fail status icon.

8. The computer-based method of claim 6 or 7, wherein the visual representation of the product structure, shape, or body that corresponds to the selected status icon appears as a portion of the computer-implemented model and is shown with a first style of appearance on the graphical user interface, and
wherein other portions of the computer-implemented model that do not correspond to the selected status icon are visually represented on the graphical user interface with a second style of appearance on the graphical user interface,
wherein the first style of appearance is visually distinct from the second style of appearance, preferably wherein the computer-implemented model is displayed on the graphical user interface simultaneously as and adjacent to a table that includes all of the status icons.

9. The computer-based method of any one of claims 1 to 8, wherein the computer-implemented simulation is a linear static structural simulation, and the analytical assumptions are stored in computer memory and are that 1) materials involved in the computer-implemented simulation are linear elastic with no material nonlinearity, 2) displacements and rotations do not exceed a predefined threshold, and 3) contact slip magnitudes do not exceed a predefined threshold.

10. The computer-based method of claim 9, wherein the linear metrics are yield, strain, sliding, and displacement.

11. The computer-based method of claim 10, further comprising:
displaying, on the graphical user interface, a comprehensive status icon for each respective one of the model elements in the hierarchical model structure for the computer-implemented model,
wherein each of the comprehensive status icons identifies, and has a visual appearance that reflects a linear analytical assumptions compliance status that corresponds to a worst one of the corresponding linear metrics for the associated one of the model elements from a perspective of compliance with the linear analytical assumptions.

12. The computer-based method of any one of claims 1 to 11, wherein computer-implemented simulation is based on a simulation model representing a real-world scenario in which a product represented by the computer-based model is subjected to various environmental boundary conditions in conducting the computer-implemented simulation.

13. A computer program comprising instructions which, when the program is executed by a computer, cause the computer to carry out the method of any one of claims 1 to 12.

14. A computer comprising:
a computer processor; and
computer-based memory operatively coupled to the computer processor, wherein the computer-based memory stores the computer program of claim 13.

15. A non-transitory computer readable medium having stored thereon the computer program of claim 13.
